Europäisches Patentamt

European Patent Office

Office européen des brevets

(19)

(11) Publication number: **0 198 507**
**A2**

## (12) EUROPEAN PATENT APPLICATION

(21) Application number: **86105367.6**

(22) Date of filing: **18.04.86**

(51) Int. Cl.⁴: **H 01 L 21/306**, H 01 L 21/31

(30) Priority: **19.04.85 JP 83838/85**

(43) Date of publication of application: **22.10.86**
**Bulletin 86/43**

(84) Designated Contracting States: **DE FR GB**

(71) Applicant: **Matsushita Electronics Corporation, 1006, Oaza-Kadoma Kadoma-shi, Osaka 571 (JP)**

(72) Inventor: **Yanagihara, Toshiya, 35-22, Gunge-Shinmachi, Takatsuki City, 569 (JP)**

(74) Representative: **Dr. Elisabeth Jung Dr. Jürgen Schirdewahn Dipl.-Ing. Claus Gernhardt, P.O. Box 40 14 68 Clemensstrasse 30, D-8000 München 40 (DE)**

(54) Method for detecting end point of etching.

(57) In making contact opening on insulation film which is provided on layer containing aluminium by selective dry etching method using reactive gas, the reactive gas containing chlorine compound gas such as $CCl_4$ is used; and then, when the contact opening reaches the layer containing aluminium, the intensity of emission spectrum of aluminium increases rapidly, accordingly it becomes possible to detect end point of the dry etching on the insulation film by detecting the intention of the emission spectrum of aluminium.

TITLE OF THE INVENTION

Method for detecting end point of etching

FIELD OF THE INVENTION AND RELATED ART STATEMENT

1. FIELD OF THE INVENTION

The present invention generally relates to an etching method, and particularly pertains to method for detecting an end point of etching in dry etching of a film formed on a layer containing aluminum.

2. DESCRIPTION OF THE RELATED ART

Recently, in various semiconductor devices, electronics circuits thereof are highly integrated. Therefore, in order to achieve a high integration, it is becoming indispensable to make aluminum wiring of high integration circuit into double layered wiring. And further, the double layered aluminum wiring also has an advantage of remoting a degree of freedom of the aluminum wiring in semi-custom LSI such as a gate array.

In case of making the aluminum wiring into the double layer configuration, it is necessary to optionally provide an opening (hereinafter referred to as contact opening) on interface insulation layer provided between both layers of double layered aluminum wiring, and to conductively connected the double layered aluminum wiring each other through the above-mentioned contact opening. With development of high integration circuit, demand for small contact opening has been getting severe. Nowadays, gas etching method using reactive gas as etching gas as an etching agent is generally used as a method for making the contact opening. The above-mentioned gas etching method is commonly known as a dry etching method.

In the dry etching method, a method of process control to detect an end point of the gas etching is adopted to finish the dry etching in high precision.

In the method of process control, the end point of the etching is generally decided by detecting change of intensity of emission spectrum from atoms, molecules, ions or the like which are contained in the insulation film.

However, in case that the contact opening is formed by the dry etching, it is impossible to detect the end point of the etching, because area of part on the insulation film to be etched is small, and amount of atoms, molecules, ions or the like which react with etching agent is small, as a result change of the intensity of the emission spectrum is very small. Therefore, hitherto, the end point of the etching has been decided by counting an etching time to be calcurated from etching rate of the insulation film between double layered aluminum wirings and thickness of the insulation film.

In the above-mentioned method for detecting the end point of the etching, when the thickness of the interface insulation film is not uniform, for a part having a thickness of above average, the contact opening does not reach underlying layer of the double layered
aluminum wiring formed on the insulation film.
Accordingly, when upper layer of the double layered
aluminum wiring is formed on the insulation film, there is
a possibility of making poor contacts. And furthermore
condition of a dry etching equipment is not always
constant, so that change of etching rate will take place.
Therefore, when the etching rate becomes lower, the poor
contacting is similarly caused.

OBJECT AND SUMMARY OF THE INVENTION

The present invention is intended to solve the
above-mentioned problems, and the purpose of the present
invention is to make etching insulation film formed on
layer containing aluminum in highly controlled condition.

Further, purpose of the present invention is to
get rid of unreliability of detection of an end point of
etching which uses ununiformities of thickness of
interface insulation film and etching rate of the
interface insulation film.

The method of the present invention enables
accurate detection of the end point of the etching, by
precisely detecting reaching of contact opening to lower
layer of the double layered aluminum wiring on the
insulation film.

Method for detecting the end point of the
etching of the present invention comprises

a step of etching insulation film formed on a layer containing aluminum by reactive gas containing chlorine compound gas,

a step of determining an end point of etching on the insulation film through by detection of emission spectrum of aluminum gas which is emitted by a reaction between the chlorine compound gas and aluminum contained in said layer containing aluminum.

While the novel features of the invention are set forth with particularity in the appended claims, the invention, both as to organization and content, will be better understood and appreciated, along with other objects and features thereof, from the following detailed description takein conjunction with the drawings.

BRIEF DESCRIPTION OF THE DRAWINGS

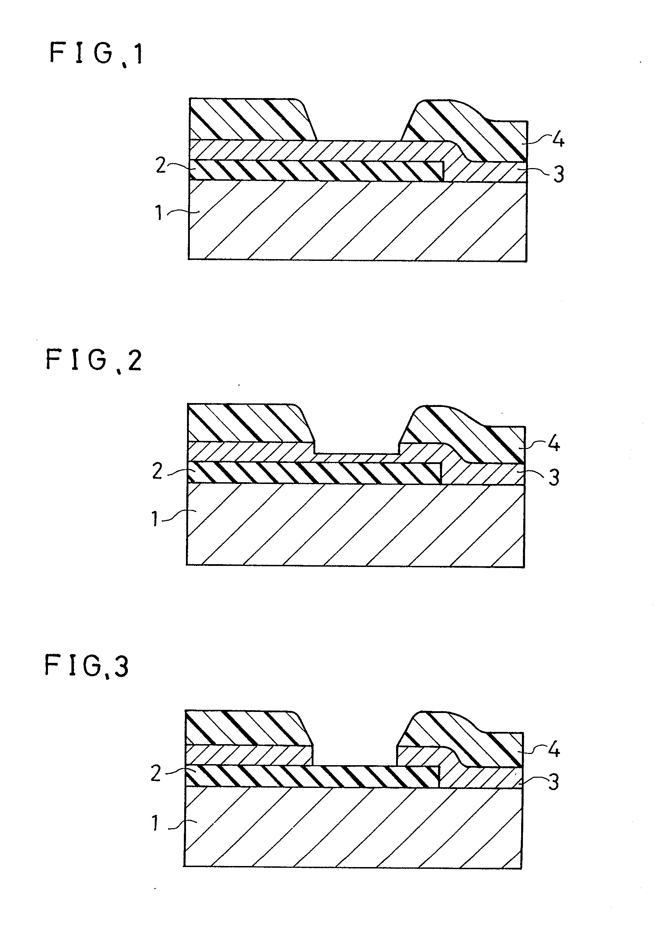

FIG.1, FIG.2 and FIG.3 are sectional views showing flow of forming process of a contact opening of an embodiment of the present invention. And FIGs.1, 2 and 3 show the steps in an order of making process of the contact opening.

DESCRIPTION OF THE PREFERRED EMBODIMENT

In the following, embodiment of the present invention is elucidated with reference to FIGs.1, 2 and 3. FIGs.1--3 show a flow of process wherein in semiconductor device having double layered aluminum wiring, a contact opening is being formed on interface insulation film provided on first aluminum wiring.

As shown in FIG.1, first aluminum wiring 2 is provided on the substrate 1. Phosphor silicate glass film (hereinafter referred to as PSG film) as the interface insulation film 3 is formed on the first aluminum wiring 2 by chemical vapor deposition method. And then a resist mask 4 by which position and size of the contact opening is fixed is paterned on the PSG film 3. Thereafter, the PSG film 3 is etched by using mixed gas of $CHF_3$, $O_2$ and $CCl_4$ as reactive gas. Not only the PSG film but also NSG film, silicon nitride film and composite film made of at least two members selected from the group consisting of the PSG film, NSG film and silicon nitride film can be used for the interface insulation film. As shown in FIG.2, the PSG film 3 is gradually etched by $CHF_3$ and $O_2$. And the contact opening reaches the first aluminum wiring 2 and is made into a shape like as shown in FIG.3. As a result, reaction between aluminum and etching gas takes place at exposed opening part of the first aluminum wiring 2, intensity of emission spectrum of aluminum of 396 nm increases. And, by observing the increase of the intensity of the emission spectrum the end point of etching is detected.

Even in case that area of a part to be etched is very small as the contact opening, the end point of the etching can be detected according to the present invention, because the intensity of the aluminum emission spectrum of 396 nm is enough large. And furthermore, the method for detecting the end point of the etching of the present invention can be used not only to make semiconductor devices having the double layered aluminum wiring but also to form the contact openings on the interface insulation film between multilayered aluminum wirings formed on double layered wiring.

Moreover, application of the present invention should not be limited to the aluminum wiring layer. Even when the aluminum wiring layer is replaced by other layer containing aluminum, the present invention can be used to detect a time for stopping the etching at the time when the etching reaches the layer containing aluminum.

As mentioned above, by the present invention, it becomes possible to form accurately formed contact openings instead of conventional poor qualities of contact openings and contact between both layers of the double layered aluminum wiring.

While specific embodiments of the invention have been illustrated and described herein, it is realized that modifications and changes will occur to those skilled in the art. It is therefore to be understood that the appended claims are intended to cover all modifications and changes as fall within the true spirit and scope of the invention.

WHAT IS CLAIMED IS:

1.      Method for detecting end point of etaching comprising:

        a step of etching insulation film (3) formed on a layer (2) containing aluminum by reactive gas containing chlorine compound gas,

        a step of determining an end point of etching on said insulation film (3) through detection of emission spectrum of aluminum which is emitted by a reaction between said chlorine compound gas and aluminum contained in said layer (2) containing aluminum.

2.      Method for detecting end point of etching in accordance with claim 1 wherein,

        said insulation film (3) is of PSG film.

3.      Method for detecting end point of etching in accordance with claim 1 wherein,

        said insulation film (3) is of NSG film.

4.      Method for detecting end point of etching in accordance with claim 1 wherein,

        said insulation film (3) is of silicon nitride film.

5.      Method for detecting end point of etching in accordance with claim 1 wherein,

        said insulation film (3) is of composite film made of at least two members selected from the group consisting of the PSG film, NSG film and silicon nitride film.

6.      Method for detecting end point of etching in accordance with claim 1 wherein,

said reactive gas is fluorine compound gas containing chlorine compound gas.

7.      Method for detecting end point of etching in accordance with claim 1 wherein,

said reactive gas contains $CCl_4$.

8.      Method for detecting end point of etching comprising:

a step of etching insulation film formed on an aluminum layer by reactive gas containing chlorine compound gas.

a step of determining an end point of etching on said insulation film through detection of emission spectrum of aluminum which is emitted by a reaction between said chlorine compound gas and aluminum in said aluminum layer.

9.      Method for detecting end point of etching in accordance with claim 8 wherein,

said insulation film is of PSG film.

10.     Method for detecting end point of etching in accordance with claim 8 wherein,

said insulation film is of NSG film.

11.     Method for detecting end point of etching in accordance with claim 8 wherein,

said insulation film is of silicon nitride film.

12.     Method for detecting end point of etching in accordance with claim 8 wherein,

said insulation film (3) is of composite film made of at least two members selected from the group consisting of the PSG film, NSG film and silicon nitride film.

13. Method for detecting end point of etching in accordance with claim 8 wherein,

said reactive gas is fluorine compound gas containing chlorine compound gas.

14. Method for detecting end point of etching in accordance with claim 8 wherein,

said reactive gas contains $CCl_4$.

15. Method for detecting end point of etching in the process of making contact opening on insulation film formed on aluminum wiring layer (2) by selective etching using

reactive gas containing $CCl_4$, comprising:

a step of etching insulation film (3) formed on an

aluminum wiring layer (2) by reactive gas containing $CCl_4$ gas,

a step of determining an end point of etching on said insulation film (3) through detection of emission spectrum of aluminum which is emitted by a reaction

between said $CCl_4$ gas and aluminum of said aluminum wiring

layer. (2)

9

1/1

FIG.1

FIG.2

FIG.3